# EUROPÄISCHE PATENTSCHRIFT

(11) **EP 0 730 349 B1**
(45) Veröffentlichungstag und Bekanntmachung des Hinweises auf die Patenterteilung: **07.02.2001**
(21) Anmeldenummer: 95117231.1
(22) Anmeldetag: 02.11.1995
(51) Int. Cl.: H03K 17/56

(54) **Schaltung zum Ein- und Ausschalten einer elektrischen Last**
Switch circuit for turn-on and to turn off an electrical load
Circuit à enclencher et déclencher une charge électrique

(30) Priorität: 01.03.1995 DE 19507072
(43) Veröffentlichungstag der Anmeldung: 04.09.1996
(73) Patentinhaber: ROBERT BOSCH GMBH, 70442 Stuttgart (DE)
(72) Erfinder: Krieger, Klaus, D-73249 Wernau (DE); Boettigheimer, Andreas, Ing., D-72639 Neuffen (DE); Schmidt, Jürgen, D-73614 Schorndorf (DE)

(56) Entgegenhaltungen:
- EP-A- 0 011 680
- EP-A- 0 413 938
- EP-A- 0 569 114
- DE-A- 3 338 627
- DE-A- 3 838 962
- DE-A- 3 839 156
- DE-A- 4 413 194
- US-A- 4 345 164
- US-A- 5 343 084

## Beschreibung

### Stand der Technik

Die Erfindung geht aus von einer Schaltung zum Ein- und Ausschalten einer elektrischen Last nach der Gattung des unabhängigen Anspruchs. Aus der DE-A 33 38 627 ist eine gattungsgemäße Schaltung bekannt geworden, die eine Reihenschaltung eines Bipolartransistors und eines Feldeffekttransistors enthält. Die Reihenschaltung der beiden unterschiedlichen Transistortypen ermöglicht das Beherrschen hoher Sperrspannungen, obwohl ein Feldeffekttransistor verwendet werden kann, der für wesentlich niedrigere Sperrspannungen ausgelegt ist. In Abhängigkeit von einem externen Schaltsignal bereiten Treiberschaltungen die für die beiden Transistoren benötigten Steuersignale auf. Im einfachsten Fall kann einer der Transistoren unmittelbar vom externen Schaltsignal ein- und ausgeschaltet werden. Zur Vermeidung von Schäden an einem der Transistoren ist es unerläßlich, daß die beiden Transistoren der vorbekannten Schaltung stets gleichzeitig vom externen Schaltsignal ein- oder ausgeschaltet werden.

Aus der EP-A 11 680 ist eine in einem Airbag-Steuergerät enthaltene Endstufenschaltung bekannt geworden, die aus Sicherheitsgründen zwei in Reihe mit der Last geschaltete Schalttransistoren aufweist. Als Last ist ein Heizelement vorgesehen, das eine Treibladung zum Aufblasen des Airbags thermisch zündet. Komparatoren, die an der Schaltstrecke eines der beiden in Reihe geschalteten Endstufentransistoren angeschlossen sind, ermöglichen eine Funktionskontrolle der Transistoren durch Ein- und Ausschalten eines der beiden Transistoren. Die vorbekannte Endstufenschaltung ermöglicht ein zuverlässiges Einschalten einer elektrischen Last. Der Ausschaltvorgang spielt dagegen keine Rolle.

Der Erfindung liegt die Aufgabe zugrunde, eine Schaltung zum zuverlässigen Ein- und Ausschalten einer elektrischen Last anzugeben.

Die Aufgabe wird durch die im unabhängigen Anspruch angegebenen Merkmale gelöst.

### Vorteile der Erfindung

Die erfindungsgemäße Schaltung zum Ein- und Ausschalten einer elektrischen Last weist den Vorteil einer erhöhten Sicherheit auf, die zunächst dadurch erzielt wird, daß die verwendeten Halbleiterschalter unterschiedliche Eigenschaften aufweisen. Vorgesehen sind wenigstens zwei in Reihe mit der Last geschaltete Halbleiterschalter, wobei der erste Halbleiterschalter ein Bipolartransistor und der zweite Halbleiterschalter ein Feldeffekttransistor ist. Mechanische, elektrische und insbesondere thermische Einflüsse wirken sich auf den Bipolartransistor und den Feldeffekttransistor unterschiedlich aus. Ein gleichzeitiger Ausfall sämtlicher Halbleiterschalter ist deshalb unwahrscheinlicher als der Ausfall lediglich eines Halbleiterschalters.

Eine erfindungsgemäß vorgesehene Auswahlschaltung, die mit ihren Schaltsignalen die Bereitstellung von Steuersignalen für die Halbleiterschalter unabhängig vom externen Schaltsignal ermöglicht, wobei die Auswahlschaltung den Bipolartransistor und den Feldeffekttransistor nicht gleichzeitig schaltet, erhöht die Sicherheit zusätzlich durch die Möglichkeit, eine Diagnose der Halbleiterschalter durchzuführen.

Vorteilhafte Ausgestaltungen und Weiterbildungen der erfindungsgemäßen Schaltung ergeben sich aus abhängigen Ansprüchen.

Eine vorteilhafte Weiterbildung der erfindungsgemäßen Schaltung sieht den Einsatz eines Invertierers vor, der das von einer Treiberschaltung für eine der Halbleiterschaltergruppen bereitgestellte Steuersignal invertiert. Diese Weiterbildung stellt sicher, daß bei einem Defekt, bei dem beide Steuersignale einem Einschaltsignal entsprechen würden, die Last dennoch abgeschaltet bleibt.

Eine andere vorteilhafte Weiterbildung sieht vor, daß die an der Last abfallende Spannung in einem Komparator mit einem ersten Schwellenwert verglichen wird. Der Komparator gibt ein Signal ab, das den Einschaltzustand der Last anzeigt. Dieses Signal ermöglicht eine Überprüfung der Halbleiterschaltergruppen unter Verwendung eines Vergleichers, der beispielsweise das externe Schaltsignal mit dem Schaltzustand der Last vergleicht. Bei Abweichungen wird beispielsweise ein Warnsignal ausgelöst und sichergestellt, daß ein Einschalten der Last nicht mehr möglich ist.

Mit der Auswahlschaltung kann unabhängig vom externen Schaltsignal erst die eine und dann die andere Halbleiterschaltergruppe eingeschaltet werden. Liegt jetzt dennoch ein vom Komparator festgestellter Einschaltzustand der Last vor, so kann die defekte Halbleiterschaltergruppe angegeben werden.

Eine andere vorteilhafte Ausgestaltung sieht vor, daß die Auswahlschaltung zwischen einer ersten und zweiten Zeitdauer der Steuersignalvorgabe unterscheidet. Die erste Zeitdauer kann derart festgelegt werden, daß ein elektrischer Verbraucher, der die elektrische Last enthält, von dem kurzzeitigen Ein- oder Ausschalten der elektrischen Last nicht weiter beeinflußt ist. Durch die Vorgabemöglichkeit einer zweiten Zeitdauer, die länger ist als die erste Zeitdauer, kann neben der Überprüfung der Last eine Überprüfung des die Last enthaltenden Verbrauchers stattfinden. Die zweite Zeitdauer ist derart festzulegen, daß ein Signal, welches das Arbeiten des Verbrauchers anzeigt, seinen Zustand ändert. Damit ist beispielsweise ein Abschalttest realisierbar.

Die erfindungsgemäße Schaltung ist insbesondere geeignet zum Ein- und Ausschalten eines Magnetventils als elektrische Last. Das Magnetventil ist vorzugsweise in einem öl- oder gasbetriebenen Heizgerät eingesetzt. In dieser Anwendung ist die ordnungsgemäße Funktion der Halbleiterschalter sowie des Magnetventils von besonderer Wichtigkeit.

Die erfindungsgemäße Schaltung kann in der Anwendung bei einem Heizgerät in mehrfacher Ausfertigung enthalten sein. Aus Sicherheitsgründen ist beispielsweise eine Serienschaltung von zwei Magnetventilen vorgesehen, die jeweils mit der erfindungsgemäßen Schaltung ein- und ausgeschaltet werden. Die beschriebenen Sicherheitskonzepte, die sich auf eine Schaltung bezogen haben, können vorteilhafter Weise die weiteren Schaltungen einbeziehen.

Weitere vorteilhafte Weiterbildungen und Ausgestaltungen der erfindungsgemäßen Schaltung zum Ein- und Ausschalten einer elektrischen Last ergeben sich aus weiteren abhängigen Ansprüchen und aus der folgenden Beschreibung.

### Zeichnung

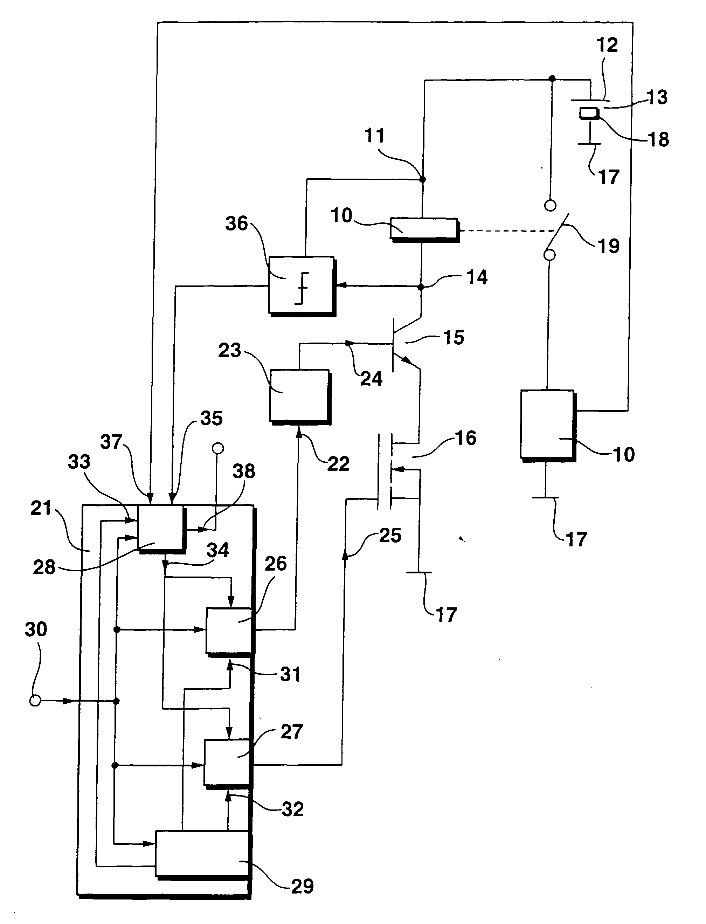

Die Figur zeigt ein Blockschaltbild einer erfindungsgemäßen Schaltung zum Ein- und Ausschalten einer elektrischen Last.

Die Figur zeigt eine elektrische Last 10, deren erster Anschluß 11 mit einem ersten Anschluß 12 einer Energiequelle 13 verbunden ist. Ein zweiter Anschluß 14 der Last 10 ist mit einem ersten Halbleiterschalter 15 verbunden, der in Reihe geschaltet ist mit einem zweiten Halbleiterschalter 16. Der zweite Halbleiterschalter 16 ist mit einer Masse 17 verbunden, an der auch ein zweiter Anschluß 18 der Energiequelle 13 angeschlossen ist.

Die Last 10 löst eine Funktion 19 in einem Verbraucher 20 aus. Im gezeigten Ausführungsbeispiel entspricht die Funktion 19 einem Schaltvorgang, der den Verbraucher 20 mit der Energiequelle 13 verbindet.

Anstelle des ersten und des zweiten Halbleiterschalters 15, 16 kann eine erste Gruppe von Halbleiterschaltern 15 und eine zweite Gruppe von Halbleiterschaltern 16 vorgesehen sein. Der erste Halbleiterschalter 15 erhält ein von einer Steuerschaltung 21 bereitgestelltes erstes Steuersignal 22 zugeleitet, das ein Invertierer 23 in ein invertiertes Steuersignal 24 umsetzt. Ein zweites Steuersignal 25, das dem zweiten Halbleiterschalter 16 zugeführt ist, stellt die Steuerschaltung 21 unmittelbar bereit.

Die Steuerschaltung 21 enthält eine erste und zweite Treiberschaltung 26, 27, einen Vergleicher 28 sowie eine Auswahlschaltung 29. Den beiden Treiberschaltungen 26, 27, dem Vergleicher 28 und der Auswahlschaltung 29 sind ein externes Schaltsignal 30 zugeführt.

Die Auswahlschaltung 29 gibt an die erste Treiberschaltung 26 ein erstes Schaltsignal 31 und an die zweite Treiberschaltung 27 ein zweites Schaltsignal 32 ab. Weiterhin gibt die Auswahlschaltung 29 ein Statussignal 33 ab, das dem Vergleicher 28 zugeleitet ist.

Die erste Treiberschaltung 26 stellt das erste Steuersignal 22 und die zweite Treiberschaltung 27 das zweite Steuersignal 25 bereit.

Der Vergleicher 28 erzeugt ein Abschaltsignal 34, das den beiden Treiberschaltungen 26, 27 zugeleitet ist. Weiterhin gibt der Vergleicher 33 ein Alarmsignal 38 nach außen ab.

Der Vergleicher erhält ein Einschaltzustandssignal 35 zugeführt, das ein Komparator 36 abgibt. Der Komparator 36 ist mit den beiden Anschlüssen 11, 14 der Last 10 verbunden und vergleicht die an der Last 10 auftretende Spannung mit einem vorgegebenen Schwellenwert.

Der Vergleicher 28 erhält weiterhin ein Verbraucheraktivitätssignal 37 zugeleitet, das der Verbraucher 20 bereitstellt.

Die erfindungsgemäße Schaltung zum Ein- und Ausschalten der Last 10 arbeitet folgendermaßen:

Die erfindungsgemäße Schaltung ist zum Ein- und Ausschalten der Last 10 vorgesehen. Die Reihenschaltung der ersten Halbleiterschaltergruppe 15, die den Bipolartransistor enthält, mit der zweiten Halbleiterschaltergruppe 16, die den Feldeffekttransistor enthält, erhöht erheblich die Sicherheit der Schaltung. Ein Defekt in einer der beiden Halbleiterschaltergruppen 15, 16 hat noch nicht zur Folge, daß die Last 10 zwangsläufig eingeschaltet wird. Die erhöhte Sicherheit ist insbesondere bei der Auslösung von sicherheitsrelevanten Funktionen 19 durch die elektrische Last 10 erforderlich. Die Halbleiterschalter der ersten Gruppe 15 werden vom invertierten Steuersignal 24 und die Halbleiterschalter der zweiten Gruppe 16 vom zweiten Steuersignal 25 angesteuert. Die Erhöhung der Anzahl von Halbleiterschaltern, die in Reihe geschaltet sind, weist den Vorteil einer weiteren Erhöhung der Sicherheit auf.

Eine andere besonders vorteilhafte Maßnahme zur Erhöhung der Sicherheit sieht den Invertierer 23 vor, der das erste Steuersignal 22 invertiert und als invertiertes Steuersignal 24 dem ersten Halbleiterschalter 15 zuführt. Wesentlich ist es, daß der Invertierer 23 ein unabhängiges Schaltungsteil von der Steuerschaltung 21 bildet. Die Steuerschaltung 21 ist vorzugsweise in einem Mikroprozessor oder einem anderen herstellerseitig programmierbaren logischen Bauelement realisiert. Sofern bei einem Defekt der Steuerschaltung 21 der Zustand auftreten kann, daß die beiden Treiberschaltungen 26, 27 Steuersignale 22, 25 mit gleichem Pegel abgeben, verhindert der Invertierer 23 zuverlässig ein fehlerhaftes Einschalten der Last 10.

Eine andere Vorteilhafte Maßnahme ermöglicht eine weitere Erhöhung der Betriebssicherheit durch das Auswerten des vom Komparator 36 bereitgestellten Einschaltzustandssignals 35, das dem Vergleicher 28 zugeführt ist. Der Komparator 36 vergleicht die an der Last 10 auftretende Spannung mit einem vorgegebenen Schwellenwert, der einem Einschaltzustand der Last 10 entspricht.

Eine erste Maßnahme sieht eine Plausibilitätskontrolle vor, der das Einschaltzustandssignal 35, das der Steuerschaltung 21 zugeführte externe Schaltsignal 30 sowie das Verbraucheraktivitätssignal 37 zugrundegelegt sind. Eine erste Plausibilitätskontrolle liefert der Vergleich des Einschaltzustandssignals 35 mit dem externen Schaltsignal 30. Bei dieser Plausibilitätskontrolle findet eine Überprüfung der Halbleiterschalter 15, 16 statt. Eine Überprüfung des ersten Halbleiterschalters 15 schließt eine Überprüfung des Invertierers 23 sowie der ersten Treiberschaltung 26 ein. Eine Überprüfung des zweiten Halbleiterschalters 16 schließt eine Überprüfung der zweiten Treiberschaltung 27 ein.

Ein fehlerhafter Zustand liegt vor, wenn bei einem externen Schaltsignal 30, das einem eingeschalteten Zustand der Last 10 entspricht, das Schaltzustandssignal 35 nicht auftritt oder wenn bei einem externen Schaltsignal 30, das dem abgeschalteten Zustand der Last 10 entspricht, ein Einschaltzustandssignal 35 auftritt. Stellt der zweite Vergleicher 28 durch den Signalvergleich fest, daß ein derartiger Fehler vorliegt, so veranlaßt der Vergleicher 28 die Ausgabe des Abschaltsignals 34 sowie gegebenenfalls die Ausgabe des Alarmsignals 38. Die Last 10 und der die Last 10 enthaltende Verbraucher 20 sind mit dieser Maßnahme in den sicheren abgeschalteten Zustand überführbar.

Eine andere Plausibilitätskontrolle bezieht den Verbraucher 20 ein. Der zweite Vergleicher 28 kann das Verbraucheraktivitätssignal 37 sowohl mit dem Einschaltzustandssignal 35 als auch mit dem externen Schaltsignal 30 vergleichen. Insbesondere aus einem Vergleich des Verbraucheraktivitätssignals 37 mit dem Einschaltzustandssignal 35 der Last 10 kann auf einen Defekt im Verbraucher 20 geschlossen werden. Ein Abschalten des Verbrauchers 20 bei einem festgestellten Einschaltzustandssignal 35 der Last 10 ist dann allerdings nicht möglich, da keine weitere Eingriffsmöglichkeiten in den Verbraucher 20 vorgesehen sind. Der zweite Vergleicher 28 kann aber in jedem Fall das Alarmsignal 38 abgeben.

Eine besonders vorteilhafte weitere Möglichkeit der Funktionskontrolle bietet die erfindungsgemäß vorgesehene Auswahlschaltung 29. Die Auswahlschaltung 29 ermöglicht über das erste oder zweite Schaltsignal 31, 32 sowohl ein Einschalten als auch ein Ausschalten entweder des ersten Halbleiterschalters 15 oder des zweiten Halbleiterschalters 16 oder gleichzeitig beider Halbleiterschalter 15, 16. Der wesentliche Vorteil liegt zum einen darin, daß die Auswahlschaltung 29 die Schaltsignale 31, 32 getrennt für die beiden Halbleiterschalter 15, 16 bereitstellen kann und zum anderen, daß die Bereitstellung der Schaltsignale 31, 32 unabhängig vom externen Schaltsignal 30 erfolgen kann. Es ist somit möglich, einen Halbleiterschalter 15, 16 ausfindig zu machen, der entweder ständig im leitenden Zustand ist oder der nicht mehr eingeschaltet werden kann.

Der wesentliche Vorteil, der durch die Auswahlschaltung 29 gegeben ist, liegt in der Möglichkeit der Plausibilitätskontrolle sowohl im abgeschalteten als auch insbesondere im eingeschalteten Zustand der Last 10. Sämtliche in Verbindung mit dem externen Schaltsignal 30 erwähnten Plausibilitätskontrollen sind mit der Auswahlschaltung 29 auf flexible Weise möglich. Das von der Auswahlschaltung 29 bereitgestellte Statussignal 33 liefert dem Vergleicher 28 stets die Information, welcher der Halbleiterschalter 15, 16 ein- oder ausgeschaltet ist. Insbesondere liefert das Statussignal 33 die Information, daß die Last 10 mit den Schaltsignalen 31, 32 eingeschaltet oder ausgeschaltet ist. Mit dem Alarmsignal 38, das gegebenenfalls ausgegeben wird, kann gleichzeitig angegeben werden, welcher Halbleiterschalter 15, 16 defekt ist.

Eine besonders vorteilhafte Maßnahme sieht vor, daß die Auswahlschaltung 29 die zeitliche Dauer der beiden Schaltsignale 31, 32 festlegen kann. Mit dieser Maßnahme können besondere Betriebszustände des Verbrauchers 20 berücksichtigt werden.

Die Festlegung auf eine erste kurze Zeitdauer ist vorzugsweise zur Überprüfung der Halbleiterschalter 15, 16 vorgesehen, die auf die bereits beschriebenen Art und Weise erfolgt. Die erste Zeitdauer ist auf einen Wert festzulegen, bei dem der Verbraucher 20 sowohl im abgeschalteten als auch im eingeschalteten Zustand unbeeinflußt bleibt. Ein solcher Verbraucher weist beispielsweise eine Verzögerungszeit zwischen dem Ein-/Ausschalten und dem daraus resultierenden Ein- oder Ausschaltzustand auf.

Die Festlegung auf eine zweite längere Zeit ist dagegen vorgesehen, um die Last 10 selbst überprüfen zu können. In Abhängigkeit von der Ausgestaltung der Last 10 kann ein Zustand auftreten, bei dem die Last 10 defekt ist, obwohl das Einschaltzustandssignal 35 nicht vorliegt. Ein solcher Zustand kann beispielsweise bei einem Relais oder beipielsweise bei einem Magnetventil auftreten, wobei die Magnetwicklung stromlos ist, aber die Relaiskontakte kleben oder das Magnetventil im geöffneten Zustand verklemmt ist. Gibt die Auswahlschaltung 29 die Abschaltsignale 31, 32 mit der längeren Zeitdauer aus, bei der eine Reaktion des Verbrauchers 20 feststellbar ist, kann aufgrund des Verbraucheraktivitätssignals 37 festgestellt werden, daß die Last 10 defekt ist, wobei aber das Einschaltzustandssignal 35 korrekt vorliegt.

Die erfindungsgemäße Schaltung eignet sich insbesondere zur Verwendung in sicherheitsrelevanten Verbrauchern 20, welche die Last 10 enthalten. Ein solcher Verbraucher 20 ist beispielsweise ein öl- oder insbesondere ein gasbetriebenes Heizgerät. Als Last 10 ist beispielsweise ein Magnetventil vorgesehen, das einen Gasfluß freigibt oder sperrt. Das Verbraucheraktivitätssignal 37 ist bei einem öl- oder gasbetriebenen Heizgerät vorzugsweise ein Flammenüberwachungssignal.

In sicherheitsrelevanten Verbrauchern 20 kann die erfindungsgemäß vorgeschlagene Schaltung mehrfach vorhanden sein. Beispielsweise kann eine Reihenschaltung mit zwei Magnetventilen bei einem öl- oder gasbetriebenen Heizgerät vorgesehen sein. Die Diagnosemöglichkeiten können ohne weiteres über mehrere Lasten 10 erstreckt werden. Insbesondere ist es möglich, eine der mehreren vorhandenen Lasten 10 unter Einbeziehung des Verbraucheraktivitätssignals 37 als defekt zu erkennen, wenn eine Last 10 eingeschaltet ist und auf die andere Last 10 das beschriebene Vorgehen angewendet wird.

## Patentansprüche

1. Schaltung zum Ein- und Ausschalten einer elektrischen Last (10), mit wenigstens zwei in Reihe mit der Last (10) geschalteten Halbleiterschaltern (15, 16), wobei der erste Halbleiterschalter (15) ein Bipolartransistor und der zweite Halbleiterschalter (16) ein Feldeffekttransistor ist, dadurch gekennzeichnet, daß eine erste Treiberschaltung (26) vorgesehen ist, die ein erstes Steuersignal (22) zum Schalten des Bipolartransistors (15) bereitstellt, daß eine zweite Treiberschaltung (27) vorgesehen ist, die ein zweites Steuersignal (25) zum Schalten des Feldeffekttransistors (16) bereitstellt, daß die Treiberschaltungen (26, 27) die Halbleiterschalter (15, 16) in Abhängigkeit von einem externen Schaltsignal (30) gleichzeitig entweder Ein- oder Ausschalten, daß eine Auswahlschaltung (29) vorgesehen ist, die mit einem ersten Schaltsignal (31), das der ersten Treiberschaltung (26) zugeführt ist, und die mit einem zweiten Schaltsignal (32), das der zweiten Treiberschaltung (27) zugeführt ist, die von den Treiberschaltungen (26, 27) bereitgestellten Steuersignale (22, 25) jeweils unabhängig vom externen Schaltsignal (30) steuert, wobei die Auswahlschaltung (29) das erste und zweite Schaltsignal (31, 32) getrennt voneinander bereitstellt, so daß die Auswahlschaltung (29) den Bipolartransistor (15) und den Feldeffekttransistor (16) nicht gleichzeitig schaltet.

2. Schaltung nach Anspruch 1, dadurch gekennzeichnet, daß ein Invertierer (23) vorgesehen ist, der das erste Steuersignal (22) invertiert und als invertiertes Steuersignal (24) der ersten Halbleiterschaltergruppe (15) zuführt, und daß das zweite Steuersignal (25) der zweiten Halbleiterschaltergruppe (16) unmittelbar zugeführt ist.

3. Schaltung nach Anspruch 1, dadurch gekennzeichnet, daß ein Komparator (36) vorgesehen ist, der die an der Last (10) auftretende Spannung mit einem vorgegebenen Schwellenwert vergleicht und der ein Signal (35) abgibt, das einen Einschaltzustand der Last (10) anzeigt.

4. Schaltung nach Anspruch 1 und 3, dadurch gekennzeichnet, daß ein Vergleicher (28) vorgesehen ist, der das Einschaltzustandssignal (35) und/oder ein von einem Verbraucher (20), der die Last (10) enthält, bereitgestelltes VerbraucherAktivitätssignal (37) mit wenigstens einem Signal (30, 31, 32, 33) vergleicht.

5. Schaltung nach Anspruch 4, dadurch gekennzeichnet, daß das Signal das externe Schaltsignal (30) ist.

6. Schaltung nach Anspruch 4, dadurch gekennzeichnet, daß die Auswahlschaltung (29) einen von den Schaltsignalen (31, 32) vorgegebenen Zustand der Last (10) wiedergebendes Statussignal (33) an der Vergleicher (28) abgibt.

7. Schaltung nach einem der vorhergehenden Ansprüche, dadurch gekennzeichnet, daß die Auswahlschaltung (29) die Schaltsignale (31, 32) eine erste kürzere Zeit oder eine zweite längere Zeit ausgibt.

8. Schaltung nach einem der vorhergehenden Ansprüche, dadurch gekennzeichnet, daß als Last (10) ein Magnetventil vorgesehen ist, das in einem öl- oder gasbetriebenen Heizgerät (20) angeordnet ist.

## Claims

1. Circuit for switching an electrical load (10) on and off, having at least two semiconductor switches (15, 16) connected in series with the load (10), in which case the first semiconductor switch (15) is a bipolar transistor and the second semiconductor switch (16) is a field-effect transistor, characterized in that a first driver circuit (26) is provided which produces a first control signal (22) for switching the bipolar transistor (15), in that a second driver circuit (27) is provided, which produces a second control signal (25) for switching the field-effect transistor (16), in that the driver circuits (26, 27) switch the semiconductor switches (15, 16) either on or off simultaneously as a function of an external switching signal (30), in that a selection circuit (29) is provided which uses a first switching signal (31), which is supplied to the first driver circuit (26), and a second switching signal (32), which is supplied to the second driver circuit (27) to control each of the control signals (22, 25), which are produced by the driver circuits (26, 27), independently of the external switching signal (30), with the selection circuit (29) producing the first and second switching signals (31, 32) separately from one another, so that the selection circuit (29) does not switch the bipolar transistor (15) and the field-effect transistor (16) simultaneously.

2. Circuit according to Claim 1, characterized in that an inverter (23) is provided which supplies the first control signal (22) inverted and as an inverted control signal (24) to the first semiconductor switch group (15), and in that the second control signal (25) is supplied directly to the second semiconductor switch group (16).

3. Circuit according to Claim 1, characterized in that a comparator (36) is provided, which compares the voltage that is present across the load (10) with a predetermined threshold value and emits a signal (35) which indicates that the load (10) is switched on.

4. Circuit according to Claims 1 and 3, characterized in that a comparator (28) is provided, which compares the switched-on state signal (35) and/or a consumer activation signal (37), which is produced by a consumer (20) which includes the load (10), with at least one signal (30, 31, 32, 33).

5. Circuit according to Claim 4, characterized in that the signal is the external switching signal (30).

6. Circuit according to Claim 4, characterized in that the selection circuit (29) emits to the comparator (28) a status signal (33) which reproduces the state of the load (10) produced by the switching signals (31, 32).

7. Circuit according to one of the preceding claims, characterized in that the selection circuit (29) outputs the switching signals (31, 32) after a first, relatively short time, or after a second, relatively long time.

8. Circuit according to one of the preceding claims, characterized in that a solenoid valve is provided as the load (10) and is arranged in a heater (20) powered by oil or gas.

## Revendications

1. Circuit de commutation d'une charge électrique (10) comprenant au moins deux semi-conducteurs de commutation (15, 16) en série avec la charge (10),
le premier semi-conducteur de commutation (15) étant un transistor bipolaire et le second (16) un transistor à effet de champ,
caractérisé en ce qu'
- il comporte un premier circuit pilote (26) fournissant un premier signal de commande (22) pour commuter le transistor bipolaire (15),
- un second circuit pilote (27) fournit un second signal de commande (25) pour commuter le transistor à effet de champ (16),
- les circuits pilotes (26, 27) commutent simultanément les semi-conducteurs de commutation (15, 16) en fonction d'un signal de commutation externe (30),
- un sélecteur (29) commande, indépendamment du signal externe (30), les signaux de commande (22, 25) fournis par les circuits pilotes (26, 27), avec un premier signal de commutation (31) appliqué au premier circuit pilote (26) et un second signal de commutation (32) appliqué au second circuit pilote (27),
- le sélecteur (29) fournissant séparément le premier et le second signal de commutation (31, 32) pour que le sélecteur (29) ne commute pas simultanément le transistor bipolaire (15) et le transistor à effet de champ (16).

2. Circuit selon la revendication 1,
caractérisé en ce qu'
un inverseur (23) inversant le premier signal de commande (22) le fournit comme signal de commande inversé (24) au premier groupe de semi-conducteurs de commutation (15), et le second signal de commande (25) est fourni directement au second groupe de semi-conducteurs de commutation (16).

3. Circuit selon la revendication 1,
caractérisé par
un comparateur (36) qui compare la tension aux bornes de la charge à un seuil prédéterminé et fournit un signal (35) indiquant l'état de branchement de la charge (10).

4. Circuit selon les revendications 1 et 3,
caractérisé par
un comparateur (28) qui compare le signal d'état de branchement (35) et/ou un signal d'activité de consommateur (37) fourni par un consommateur (20) comprenant la charge (10), à au moins un signal (30, 31, 32, 33).

5. Circuit selon la revendication 4,
caractérisé en ce que
le signal est le signal de commutation externe (30).

6. Circuit selon la revendication 4,
caractérisé en ce que
le sélecteur (29) fournit au comparateur (28) un signal d'état (33) représentant l'état de la charge (10) prédéterminé par les signaux de commutation (31, 32).

7. Circuit selon l'une quelconque des revendications précédentes,
caractérisé en ce que
le sélecteur (29) émet les signaux de commutation (31, 32) pendant une première durée courte ou une seconde durée plus longue.

8. Circuit selon l'une quelconque des revendications précédentes,
caractérisé en ce que
la charge (10) est une électrovanne équipant un appareil de chauffage au mazout ou au gaz (20).
